# EUROPÄISCHE PATENTSCHRIFT

(11) **EP 3 258 228 B1**
(45) Veröffentlichungstag und Bekanntmachung des Hinweises auf die Patenterteilung: **09.05.2018**
(21) Anmeldenummer: 16175013.8
(22) Anmeldetag: 17.06.2016
(51) Int. Cl.: G01J 1/44, G01J 1/46, H04N 5/33

(54) **LICHTEMPFÄNGER MIT LAWINENPHOTODIODEN IM GEIGER-MODUS UND VERFAHREN ZUM AUSLESEN**
LIGHT RECEIVING DEVICE WITH AVALANCHE PHOTODIODES IN GEIGER MODE AND METHOD FOR READING
RÉCEPTEUR DE LUMIÈRE AYANT DES PHOTODIODES À AVALANCHE EN MODE GEIGER ET PROCÉDÉ DE LECTURE

(43) Veröffentlichungstag der Anmeldung: 20.12.2017
(73) Patentinhaber: SICK AG, 79183 Waldkirch (DE)
(72) Erfinder: Clemens, Klaus, 79367 Weisweil (DE); Hug, Gottfried, 79183 Waldkirch (DE); Seitz, Stefan, 79341 Kenzingen (DE)

(56) Entgegenhaltungen:
- EP-A2- 2 720 012
- DE-A1-102009 043 746
- GB-A- 2 484 964
- US-A1- 2006 202 129
- MITCHELL L WOODRING ET AL: "Multiplexed avalanche photodiode arrays for radiation imaging", OPTICAL SENSING II, Bd. 4784, 16. Januar 2003 (2003-01-16), XP055324081, 1000 20th St. Bellingham WA 98225-6705 USA ISSN: 0277-786X, DOI: 10.1117/12.455977 ISBN: 978-1-62841-971-9

## Beschreibung

Die Erfindung betrifft einen Lichtempfänger mit einer Vielzahl von Lawinenphotodiodenelementen, die in einem Geiger-Modus betrieben sind, sowie ein Verfahren zum Auslesen nach dem Oberbegriff von Anspruch 1 beziehungsweise 9. Ein Lichtempfänger hat die Funktion, aus einfallendem Empfangslicht ein elektrisches Signal zu erzeugen. Die Nachweisempfindlichkeit einfacher Photodioden genügt in vielen Anwendungsfällen nicht. In einer Lawinenphotodiode (APD, Avalanche Photo Diode) löst das einfallende Licht einen kontrollierten Lawinendurchbruch (Avalanche Effect) aus. So werden die von einfallenden Photonen erzeugten Ladungsträger vervielfacht, und es entsteht ein Photostrom, der zu der Lichtempfangsintensität proportional, dabei aber wesentlich größer ist als bei einer einfachen PIN-Diode. Im sogenannten Geiger-Modus ist die Lawinenphotodiode oberhalb der Durchbruchspannung vorgespannt, so dass bereits ein einziger, durch ein einzelnes Photon freigesetzter Ladungsträger eine Lawine auslösen kann, die dann aufgrund der hohen Feldstärke sämtliche verfügbaren Ladungsträger rekrutiert. Die Lawinenphotodiode zählt somit wie der namensgebende Geigerzähler Einzelereignisse. Lawinenphotodioden im Geiger-Modus werden auch als SPAD (Single-Photon Avalanche Diode) bezeichnet.

Die hohe Strahlungsempfindlichkeit von SPADs wird in vielen Anwendungen genutzt. Dazu zählen die Medizintechnik mit CT, MRT oder Blutanalysen, die optische Messtechnik einschließlich Spektroskopie, Entfernungsmessung und dreidimensionaler Bildgebung, die Strahlendetektion in der Kernphysik oder die Verwendungen in Teleskopen für die Astrophysik.

Geiger-APDS oder SPADs sind also sehr schnelle, hochempfindliche Photodioden auf Halbleiterbasis. Ein Nachteil der hohen Empfindlichkeit ist, dass nicht nur ein Nutzlichtphoton, sondern auch ein schwaches Störereignis durch Fremdlicht, optisches Übersprechen oder Dunkeirauschen den Lawinendurchbruch auslösen kann. Dieses Störereignis trägt dann mit dem gleichen relativ starken Signal zum Messergebnis bei wie das empfangene Nutzlicht und ist davon auch aus dem Signal heraus nicht unterscheidbar. Anschließend bleibt die Lawinenphotodiode für eine Totzeit von ca. 5 bis 100 ns unempfindlich und fällt solange für weitere Messungen aus. Deshalb ist es üblich, mehrere SPADs zusammenzuschalten und statistisch auszuwerten.

Um das elektrische Signal tatsächlich nutzen zu können, muss es aus dem SPAD-Detektorelement herausgelesen oder abgegriffen werden. Herkömmliche Signalabgriffschaltungen sind jedoch langsam, können also mit hochfrequenten Signalen nicht umgehen. Außerdem werden in vielen bekannten Anwendungen die Signale der SPADs einfach zusammengefasst. Damit ist es jedoch nicht möglich, die Signale beispielsweise in einem Matrix-Bildsensor den auslösenden SPADs zuzuordnen.

Die WO 2011/117309 A2 schlägt vor, neben der Anode und Kathode für das Anlegen der Vorspannung eine dritte Elektrode an dem SPAD-Detektor vorzusehen, über welche der Geigerstrom kapazitiv ausgekoppelt wird. Dadurch soll verhindert werden, dass das Auslesen durch Schaltelemente der Vorspannung (Bias) verzögert wird. Mit dem eigentlichen Signalabgriff befasst sich das Dokument aber nicht.

Aus der GB 24 84 964 A ist ein Bildsensor bekannt, der unter anderem aus Geiger-APDs aufgebaut sein kann. Die einzelnen Detektorelemente können auf verschiedene Weise zum Auslesen gruppiert werden. In einer Ausführungsform werden jeweils alle Anoden einer selben Spalte und alle Kathoden einer selben Zeile verbunden, um "X"-Ausgänge beziehungsweise "Y"-Ausgänge zu bilden.

Die Arbeit Woodring, M. et. al "Multiplexed avalanche photodiode arrays for radiation imaging" in International Symposium on Optical Science and Technology, International Society for Optics and Photonics, Januar 2003, Seiten 199-207 befasst sich mit monolithischen Arrays von APDs. Dabei sind auf der Rückseite jeder APD doppelte Leseausgänge vorgesehen.

Die DE 10 2009 043 746 A1 offenbart ein Laser-Scanning-Mikroskop, in dem als Detektor unter anderem APDs vorgesehen sein können. Das elektrische Ausgangssignal des Detektors wird aufgeteilt und zwei parallelen Auswertekanälen zugeführt.

In der US 2006/0202129 A1 wird ein SPAD-Array vorgestellt, bei dem die SPADs jeweils mit einem von mehreren Ausleseschaltkreisen verbunden werden.

Die EP 2 720 012 A2 beschreibt einen Hochgeschwindigkeits-Bildsensor mit einer orthogonalen Auslesearchitektur.

Es ist daher Aufgabe der Erfindung, das Auslesen einer Vielzahl von Lawinenphotodioden zu verbessern.

Diese Aufgabe wird durch einen Lichtempfänger mit einer Vielzahl von Lawinenphotodiodenelementen, die in einem Geiger-Modus betrieben sind, sowie ein Verfahren zum Auslesen nach Anspruch 1 beziehungsweise 9 gelöst. Die Lawinenphotodiodenelemente weisen jeweils einen ersten und zweiten Anschluss auf. Die Erfindung geht nun von dem Grundgedanken aus, die Lawinenphotodiodenelemente zweifach auszulesen. Dazu werden zwei Signalabgriffschaltungen mit jeweils einem der Anschlüsse verbunden, so dass dann die Information des Lawinenphotodiodenelements in zwei Signalen zur Verfügung steht. Die Lawinenphotodiodenelemente werden also nicht nur einmal ausgelesen, sondern doppelt, wobei das erneute Auslesen der zweiten Signalabgriffschaltung parallel und gleichzeitig zum Auslesen der ersten Signalabgriffschaltung erfolgen kann.

Die Erfindung hat zunächst die Vorteile eines Lichtempfängers mit Lawinenphotodiodenelementen, nämlich beispielsweise deren hohe Empfindlichkeit bis hin zur Detektion einzelner Photonen und die hohe inhärente Verstärkung. Weiterhin kann durch den doppelten Signalabgriff zusätzliche Information gewonnen werden. Unter anderen wird dadurch die Möglichkeit geschaffen festzustellen, welches Lawinenphotodiodenelement beziehungsweise welche Gruppe jeweils ein Detektionssignal ausgelöst hat, ohne dass dafür eine eigene Signalabgriffschaltung für jedes Lawinenphotodiodenelement mit entsprechend komplexer Verschaltung und hohem Flächenverbrauch nötig ist.

Die erste Signalabgriffschaltung und/oder die zweite Signalabgriffschaltung weist bevorzugt ein aktives Kopplungselement mit einem Eingang, der mit einem der Anschlüsse verbunden ist, und mit einem Ausgang auf, wobei das Kopplungselement einen Geigerstrom des jeweiligen Lawinenphotodiodenelements am Eingang auf einen in Verlauf und Pegel dem Geigerstrom entsprechenden Messstrom abbildet, indem der Eingang für den Geigerstrom einen virtuellen Kurzschluss gegen ein Potential bildet und der Ausgang von dem Eingang entkoppelt ist. Der Signalabgriff nutzt demnach ein aktives Auskoppelverfahren, das hoch empfindlich und dabei sehr schnell ist. Das Lawinenphotodiodenelement ist dabei wechselspannungsmäßig praktisch kurzgeschlossen, so dass es bei einem Auslösen der Lawine nur zu kleinen Spannungsänderungen zwischen den Anschlüssen kommt, damit auch parasitäre Kapazitäten der Lawinenphotodiodenelemente kaum umgeladen werden und sich somit nur geringfügig auf die Ausgangssignalqualität und Bandbreite auswirken.

Ein derartiger aktiver Signalabgriff ist für die Erfindung ganz besonders vorteilhaft und soll deshalb noch weiter erläutert werden. Die Lawinenphotodiodenelemente im Geiger-Modus oder SPADs wirken praktisch wie hoch lichtempfindliche Schalter, die durch Lichteinfall einen Geigerstrom auslösen. Herkömmliche Formen des Signalabgriffs sind aufgrund unzureichend optimierter Schaltungen nicht in der Lage, die sehr schnellen Abläufe bei einem Lawinendurchbruch im Messsignal widerzuspiegeln. Deshalb ist das aktive Kopplungselement vorgesehen und nicht lediglich passive Elemente wie ein Widerstand oder ein Transformator. Das aktive Kopplungselement bietet für den Geigerstrom an seinem Eingang einen virtuellen Kurzschluss gegen ein vorzugsweise festes Potential. Praktisch wird dies nur bis auf wenige Ohm oder Bruchteile von einem Ohm gelingen. Es bedeutet aber, dass der Geigerstrom nahezu vollständig aus dem Detektor, also dem jeweils auslösenden Lawinenphotodiodenelement, in die jeweilige Signalabgriffschaltung fließt und über den Kurzschluss abfließen kann, ganz anders als beispielsweise bei einem einfachen Messwiderstand. Deshalb kann die durch die Vielzahl der Lawinenphotodiodenelemente gebildete parasitäre Kapazität nicht mehr wie ein Tiefpass wirken, und es finden dort praktisch keine Umladevorgänge mehr statt. Die schnellen hochfrequenten Geigerströme können im Wesentlichen ungehindert zum verstärkenden Element abfließen. Weiter erzeugt das Kopplungselement an seinem Ausgang aktiv einen Messstrom, der dem Geigerstrom entspricht und damit insbesondere den gleichen zeitlichen Verlauf zeigt. Das aktive Kopplungselement kann außerdem durch eine Verstärkung dafür sorgen, dass der Messstrom einen für die weitere Verarbeitung geeigneten Pegel aufweist. Zugleich wird der Messstrom durch das aktive Kopplungselement nahezu vollständig von dem Geigerstrom entkoppelt. Die weitere Verarbeitung des Messstroms wirkt daher nicht auf den Geigerstrom zurück. Da der mit dem Detektionsereignis verfügbare Strom praktisch vollständig in das aktive Kopplungselement fließen kann, ergibt sich eine optimale Verstärkung mit sehr gutem Signal/Rausch-Verhältnis.

Der Verlauf des Messstroms weicht dank des aktiven Kopplungselements bevorzugt erst für Änderungen im höheren Gigahertzbereich, insbesondere oberhalb zwei oder drei GHz, durch frequenzbedingte Verluste erheblich von dem Geigerstrom ab. Erst für Frequenzen des einfallenden Lichtsignals oberhalb von einigen GHz zeigt die Abbildung des Geigerstroms auf den Messstrom deutlich spürbare frequenzbedingte Verluste. Im Gegensatz dazu fällt bei herkömmlichen Lösungen das Messsignal schon bei mittleren Frequenzen von einigen hundert MHz um mehrere Dekaden ab. Somit gelingt es mit dem aktiven Kopplungselement, auch sehr kurze Pulse und Flanken im Sub-Nanosekundenbereich aufzulösen.

Der erste Anschluss ist bevorzugt auf der Anodenseite und der zweite Anschluss auf der Kathodenseite des jeweiligen Lawinenphotodiodenelements angeordnet. Damit stören sich die beiden Abgriffe besonders wenig. Beispielsweise wird der Geigerstrom nicht etwa aufgeteilt, sondern es steht jeweils das volle Messsignal zur Verfügung. Durch den Abgriff zu beiden Seiten des Lawinenphotodiodenelements sind die beiden Signale invers zueinander, was aber durch nachgeordnete analoge Schaltungselemente oder digitale Verarbeitung problemlos kompensierbar ist.

Die Lawinenphotodiodenelemente können über den ersten Anschluss und den zweiten Anschluss vorgespannt sein. So wird die Bias- oder Vorspannung bereitgestellt, aus der sich der Lawinendurchbruch speist. Es werden dann für den Abgriff Anschlüsse genutzt, die ohnehin vorhanden sind, was den Aufbau der einzelnen Lawinenphotodiodenelemente vereinfacht.

Jeweils zwischen dem Lawinenphotodiodenelement und dem ersten Anschluss oder dem zweiten Anschluss kann eine Ladeeinheit angeordnet sein, und die Ladeeinheit ist mit einem parallel geschalteten Kondensator überbrückt. Die Ladeeinheit ist häufig ein Ladewiderstand, kann aber auch eine Stromquelle sein, und bestimmt den Aufladevorgang nach einem Lawinendurchbruch. Der Kondensator dient als Wechselstrombrücke, so dass der Geigerstrom mit seinen hochfrequenten Anteilen ungestört abgegriffen werden kann.

Die Lawinenphotodiodenelemente weisen in einer erfindungsgemäßen Alternative einen dritten Anschluss auf, wobei der erste Anschluss zum kapazitiven Auskoppeln des Geigerstroms ausgebildet ist und die Lawinenphotodiodenelemente über den zweiten Anschluss und den dritten Anschluss vorgespannt sind. Der erste Anschluss dient hier ausschließlich dem schnellen kapazitiven Signalabgriff. Es ist ein zusätzlicher dritter Anschluss vorgesehen, so dass die Lawinenphotodiodenelemente über den zweiten und dritten Anschluss vorgespannt werden. Durch den von der Bereitstellung der Vorspannung unabhängigen ersten Anschluss ist das Auslesen vereinfacht.

Die Lawinenphotodiodenelemente weisen in einer anderen erfindungsgemäßen Alternative einen dritten Anschluss und einen vierten Anschluss auf, und jeweils zwischen Lawinenphotodiodenelement und dem dritten Anschluss ist eine erste Ladeeinheit und zwischen dem Lawinenphotodiodenelement und dem vierten Anschluss eine zweite Ladeeinheit angeordnet, wobei insbesondere die Lawinenphotodiodenelemente über den dritten Anschluss und den vierten Anschluss vorgespannt sind. Die Ladeeinheit ist hier in eine erste und zweite Ladeeinheit aufgeteilt, vorzugsweise symmetrisch. Dadurch werden zwei besonders gleichartige Signale insbesondere mit vergleichbaren Dämpfungen und Latenzen abgegriffen. Die Anschlüsse für die Vorspannung und den Signalabgriff sind voneinander getrennt.

Die erste Ladeeinheit ist vorzugsweise mit einem ersten parallel geschalteten Kondensator auf den ersten Anschluss und die zweite Ladeeinheit mit einem zweiten parallel geschalteten Kondensator auf den zweiten Anschluss überbrückt. Die Kondensatoren dienen wie in dem Ausführungsbeispiel mit insgesamt nur zwei Anschlüssen als Wechselstrombrücken, um den Geigerstrom ungestört abzugreifen.

Die Lawinenphotodiodenelemente bilden vorzugsweise eine Matrixanordnung, wobei eine Vielzahl von ersten Signalabgriffschaltungen jeweils mit den ersten Anschlüssen der Lawinenphotodiodenelementen einer Spalte und eine Vielzahl von zweiten Signalabgriffschaltungen jeweils mit den zweiten Anschlüssen der Lawinenphotodiodenelemente einer Zeile verbunden ist. Es sind demnach vorzugsweise so viele erste Signalabgriffschaltungen vorhanden wie Spalten und so viele zweite Signalabgriffschaltungen wie Zeilen. Die Lawinenphotodiodenelemente einer Spalte sind über ihre ersten Anschlüsse und eine Spaltenleitung an die zuständige erste Signalabgriffschaltung, entsprechend die Lawinenphotodiodenelemente einer Zeile über ihre zweiten Anschlüsse und eine Zeilenleitung an die zuständige zweite Signalabgriffschaltung angeschlossen. Dabei sind die Rollen von ersten und zweiten Signalabgriffschaltungen, ersten Anschlüssen und zweiten Anschlüssen sowie Zeilen und Spalten nur austauschbare Namen. Der technische Vorteil liegt darin, dass die Lawinenphotodiodenelemente in systematischer Weise zweifach angeschlossen sind und darüber eine örtliche Zuordnung eines Detektionsereignisses zu einem Lawinenphotodiodenelement in der Matrix erfolgen kann. Der Lichtempfänger wird damit ortsauflösend.

Die Lawinenphotodiodenelemente bilden bevorzugt eine in Gruppen unterteilbare Linienanordnung, wobei eine Vielzahl von ersten Signalabgriffschaltungen jeweils mit den ersten Anschlüssen der Lawinenphotodiodenelemente einer Gruppe und eine Vielzahl von zweiten Signalabgriffschaltungen jeweils mit den zweiten Anschlüssen eines Lawinenphotodiodenelements aus jeder Gruppe verbunden ist. Dies ist ein Beispiel dafür, dass Lawinenphotodiodenelemente auch anders gruppiert werden können als in Zeilen und Spalten und dann durch den doppelten Signalabgriff eine Ortszuweisung eines Detektionsereignisses ermöglicht wird. In diesem Beispiel werden in einer Linienanordnung *n* Gruppen vorzugsweise jeweils mit der gleichen Anzahl von *m* Lawinenphotodiodenelementen gebildet. Es gibt dann *n* erste Signalabgriffschaltungen, eine für jede Gruppe, und *m* zweite Signalabgriffschaltungen, die mit jeweils einem Lawinenphotodiodenelement jeder Gruppe verbunden sind. Mit anderen Worten entspricht hier die Schaltungstopologie einer Matrix mit Zeilen und Spalten, die Geometrie der Lawinenphotodiodenelemente ist aber vorzugsweise linear. Der doppelte Signalabgriff kann in ähnlicher Weise auf weitere Schaltungstopologien und Anordnungen der Lawinenphotodiodenelemente angepasst werden.

Vorzugsweise sind Lawinenphotodiodenelemente parallel geschaltet und erzeugen ein gemeinsames Signal. Es bilden also mehrere Lawinenphotodioden eine Gruppe, beispielsweise ein Pixel einer Matrixanordnung. Vorzugsweise geschieht dies in systematischer Weise, etwa indem alle Lawinenphotodiodenelemente in gleich große Gruppen aufgeteilt sind. Jedes Signal beruht dann auf der Detektion mehrerer Lawinenphotodiodenelemente, wodurch SPAD-typische Effekte wie die Totzeit nach einem Detektionsereignis oder ein Fehlauslösen durch ein Störereignis statistisch abgemildert werden.

In vorteilhafter Weiterbildung weist ein optoelektronischer Sensor mindestens einen erfindungsgemäßen Lichtempfänger auf. Die Entfernung kann durch Triangulation bestimmt werden, wie in einem Triangulationstaster oder einer Stereokamera. Vorzugsweise erfolgt die Entfernungsmessung nach einem Lichtlaufzeitverfahren. In einem Pulslaufzeitverfahren wird mit einem Lichtsender ein kurzer Lichtpuls ausgesandt und die Zeit bis zum Empfang einer Remission oder Reflexion des Lichtpulses gemessen. Alternativ wird bei einem Phasenverfahren Sendelicht amplitudenmoduliert und eine Phasenverschiebung zwischen Sende- und Empfangslicht bestimmt, wobei die Phasenverschiebung ebenfalls ein Maß für die Lichtlaufzeit ist. Das Lichtlaufzeitverfahren kann in einem eindimensionalen Entfernungstaster, einem Laserscanner oder einem Bildsensor einer 3D-Kamera nach dem Lichtlaufzeitprinzip genutzt werden. Weitere nicht abschließende Anwendungen des Lichtempfängers in einem optoelektronischen Sensor sind Codelesen oder Datenübertragung oder Kombinationen dieser Anwendungen in einem Sensor.

Das erfindungsgemäße Verfahren kann auf ähnliche Weise weitergebildet werden und zeigt dabei ähnliche Vorteile. Derartige vorteilhafte Merkmale sind beispielhaft, aber nicht abschließend in den sich an die unabhängigen Ansprüche anschließenden Unteransprüchen beschrieben.

Dabei ist vorzugsweise in der ersten Signalabgriffschaltung und/oder der zweiten Signalabgriffschaltung ein mit einem der Anschlüsse verbundener Eingang eines aktiven Kopplungselements für den Geigerstrom virtuell gegen ein Potential kurzgeschlossen, so dass der Geigerstrom praktisch unverändert in das Kopplungselement fließt und dort auf einen in Verlauf und Pegel dem Geigerstrom entsprechenden Messstrom an einem Ausgang des Kopplungselements abgebildet wird, wobei der Ausgang von dem Eingang entkoppelt ist. Die Funktionsweise und Vorteile dieser aktiven Auskopplung wurden oben bereits erläutert.

Vorteilhafterweise bilden die Lawinenphotodiodenelemente eine Matrixanordnung, und jedes Lawinenphotodiodenelement wird einerseits über eine seiner Spalte zugeordnete erste Signalabgriffschaltung und andererseits über eine seiner Zeile zugeordnete zweite Signalabgriffschaltung ausgelesen. Das ermöglicht eine ortsauflösende Erfassung.

Die Erfindung wird nachstehend auch hinsichtlich weiterer Merkmale und Vorteile beispielhaft anhand von Ausführungsformen und unter Bezug auf die beigefügte Zeichnung näher erläutert. Die Abbildungen der Zeichnung zeigen in:
- Fig. 1: eine Darstellung einer Signalabgriffschaltung für ein Lawinenphotodioden-element mit einem aktiven Kopplungselement;
- Fig. 2: ein Vergleich des Frequenzgangs einer Signalabschaltung mit aktivem Kopplungselement und einer herkömmlichen Signalabgriffschaltung;
- Fig.3: eine schematische Schaltungsanordnung einer Matrix von Lawinenphotodiodenelementen mit drei Anschlüssen und jeweils doppeltem Signalabgriff für das Auslesen in Zeilen und Spalten;
- Fig. 4: eine alternative Ausführungsform der Schaltungsanordnung gemäß Figur 3 von Lawinenphotodiodenelementen mit zwei Anschlüssen;
- Fig. 5: eine weitere alternative Ausführungsform der Schaltungsanordnung gemäß Figur 3 von Lawinenphotodiodenelementen mit vier Anschlüssen;
- Fig. 6: eine Blockdarstellung einer Logik zum Zuordnen eines Detektionsereignisses zu einem Lawinenphotodiodenelement;
- Fig. 7: eine beispielshafte Schaltungsanordnung für die Logik gemäß Figur 6;
- Fig. 8: ein beispielhafter Signalverlauf an verschiedenen Punkten der Schaltungsanordnung gemäß Figur 7;
- Fig. 9: eine alternative lineare Anordnung von Lawinenphotodiodenelementen mit doppeltem Signalabgriff zur örtlichen Zuordnung von Detektionsereignissen;
- Fig. 10: eine Matrixdarstellung von Lawinenphotodiodenelementen zur Erläuterung von Übersprecheffekten; und
- Fig. 11: ein Schaltungsausschnitt einer Matrix von Lawinenphotodiodenelementen zur weiteren Erläuterung von Übersprecheffekten.

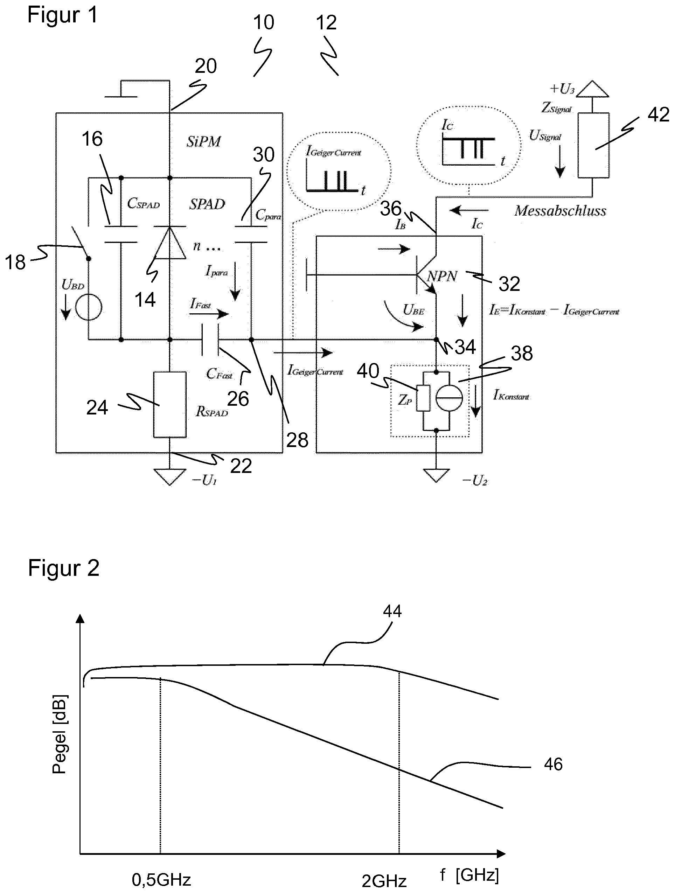

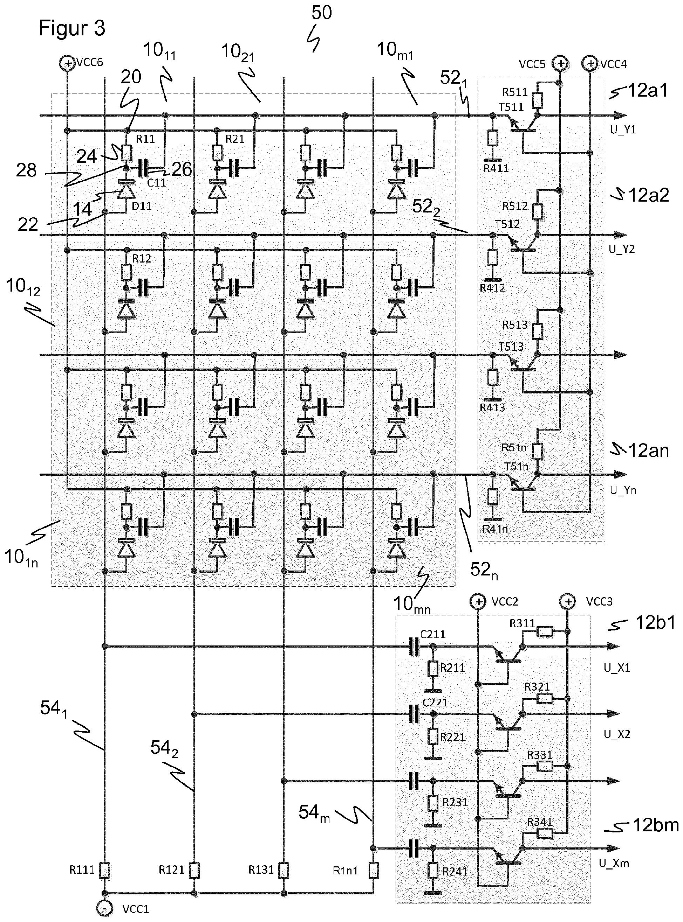

Figur 1 zeigt als Ausgangspunkt eine Darstellung eines Lawinenphotodiodenelements 10 mit einer Signalabgriffschaltung 12, die für Empfindlichkeit und Bandbreite optimiert ist. Die Erfindung betrifft eine Anordnung einer Vielzahl solcher Lawinenphotodiodenelemente mit jeweils zwei Signalabgriffen, die vorzugsweise jeweils wie in Figur 1 ausgebildet sind, und wird dann weiter unten anhand der Figuren 3 bis 11 erläutert.

Das Lawinenphotodiodenelement 10 ist als Ersatzschaltbild gezeigt. Der eigentliche Aufbau des Halbleiterbauteils wird als bekannt vorausgesetzt und nicht dargestellt. Ein entsprechendes Bauelement kann beispielsweise in einem CMOS-Prozess hergestellt werden. Die Durchbruchspannung der Lawinenphotodiodenelemente 10 ist deutlich geringer als bei herkömmlichen Lawinenphotodioden, beträgt beispielsweise höchstens 50V oder 30V.

Das Lawinenphotodiodenelement 10 zeigt zum einen das Verhalten einer Diode 14. Es hat außerdem eine Kapazität, die durch den parallel geschalteten Kondensator 16 repräsentiert wird. Ein Lawinendurchbruch wird durch mindestens ein auftreffendes Photon ausgelöst, wobei dieser Vorgang wie ein Schalter 18 wirkt. Im Bereitschaftszustand liegt über der Diode 14 zwischen einem Anschluss 20 und einem Anschluss 22 eine Spannung oberhalb der Durchbruchspannung. Erzeugt dann ein einfallendes Photon ein Ladungsträgerpaar, so schließt dies gleichsam den Schalter 18, so dass das Lawinenphotodiodenelement 10 mit Ladungsträgern geflutet wird und ein sogenannter Geigerstrom fließt. Neue Ladungsträger entstehen aber nur, solange das elektrische Feld stark genug bleibt. Wird der Kondensator 16 so weit entladen, dass die Durchbruchspannung unterschritten ist, so kommt die Lawine von selbst zum Erliegen ("passive quenching"). Danach wird der Kondensator 16 aus den Anschlüssen 20, 22 über einen Widerstand 24 aufgeladen, bis wieder eine Spannung über der Durchbruchspannung an der Diode 14 anliegt. Es gibt alternative Ausgestaltungen, in denen die Lawine von außen erkannt und daraufhin eine Entladung unter die Durchbruchspannung ausgelöst wird ("active quenching").

Während der Lawine steigt das Ausgangssignal rapide und unabhängig von der Intensität des auslösenden Lichts auf einen Maximalwert an und fällt dann nach dem Löschen der Lawine wieder ab. Die Zeitkonstante des Abfalls, welche eine Totzeit des Lawinenphotodiodenelements 10 angibt, liegt typischerweise im Bereich einiger bis einiger zehn Nanosekunden. Die Totzeit ist keine absolute Totzeit, denn sobald die Vorspannung groß genug ist, um eine Lawine zu unterstützen, kann das Ausgangssignal auch wieder ansteigen, allerdings nicht im gleichen Maße wie aus dem Bereitschaftszustand. Der Verstärkungsfaktor beträgt bis zu 10⁶ und ergibt sich im Wesentlichen aus der maximalen Anzahl von Ladungsträgern, die von der Lawine in dem Lawinenphotodiodenelement 10 rekrutiert werden können.

Die Funktion der Signalabgriffschaltung 12 ist, aus dem Geigerstrom während eines Lawinendurchbruchs ein Messsignal möglichst unter Ausnutzung des vollen Stromflusses abzuleiten, und zwar so, dass auch hochfrequente Anteile erhalten bleiben und ein hohes Signal/Rausch-Verhältnis erreicht wird. Die Signalauskopplung erfolgt vorzugsweise kapazitiv über einen Koppelkondensator 26. In der dargestellten Ausführungsform weist das Lawinenphotodiodenelement 10 einen eigenen Anschluss 28 zum Auslesen eines Messsignals aus, wobei dieser Anschluss 28 über den Koppelkondensator 26 verbunden ist. Später werden auch Alternativen zu einem solchen Lawinenphotodiodenelement 10 mit mehr oder weniger als drei Anschlüssen 20, 22, 28 vorgestellt.

In Figur 1 nicht dargestellte weitere Lawinenphotodiodenelemente bilden aus Sicht des gezeigten Lawinenphotodiodenelements 10 parasitäre Kapazitäten 30, die durch sonstige parasitäre Effekte noch erhöht sein können. Die parasitäre Kapazität 30 summiert sich aus den in praktischen Anwendungen meist zahlreichen weiteren Lawinenphotodiodenelementen und kann deshalb deutlich größer sein als die Kapazität des zugehörigen Koppelkondensators 26. Die parasitäre Kapazität 30 verhält sich wie ein Tiefpass, der hochfrequente Signale sperrt.

Die Signalabgriffschaltung 12 soll für die Erzielung hoher Geschwindigkeiten beziehungsweise Bandbreiten einen möglichst kleinen, gleichzeitig für eine hohe Empfindlichkeit einen großen Signalwiderstand aufweisen. Um diesen widersprüchlichen Anforderungen gerecht zu werden, nutzt die Signalabgriffschaltung 12 eine aktive Schaltungslösung mit einem aktiven Kopplungselements 32, das in Figur 1 als bipolarer NPN-Transistor in Basisschaltung ausgebildet ist. Andere aktive Elemente, insbesondere andere Transistoren (FET), eine andere Polarität (PNP) oder eine andere Verschaltung (Emitterschaltung) sind denkbar. Außerdem können statt einer einstufigen Schaltung auch mehrere Transistoren eingesetzt werden.

Das aktive Kopplungselement 32 hat nun mehrere erhebliche Vorteile für den Signalabgriff. Zum einen bietet es für den kapazitiv als Strompuls ausgekoppelten Geigerstrom praktisch keinen Widerstand, bildet also einen virtuellen Kurzschluss. Das wird praktisch nicht ganz erreicht, aber weniger als ein Ohm ist durchaus möglich. Dies führt dazu, dass es über der parasitären Kapazität 30 trotz der Lawine keine relevanten Spannungsänderungen und damit dort keine Umladevorgänge und keinen Stromfluss gibt. Dem aktiven Kopplungselement 32 steht daher eingangsseitig nahezu der gesamte durch den Koppelkondensator 26 fließende Geigerstrom zur Verfügung. Ohne den virtuellen Kurzschluss würden dagegen deutlich spürbare Anteile des Geigerstroms in der parasitären Kapazität 30 verloren gehen, und vor allem die schnellen, hochfrequenten Signalanteile durch das Tiefpassverhalten unterdrückt.

Zum zweiten erzeugt das aktive Kopplungselement 32 ausgangsseitig einen Messstrom, der in seinem zeitlichen Verlauf und Pegel dem Geigerstrom entspricht. Dabei kann das aktive Kopplungselement 32 den Messstrom durch seine Übertragungsfunktion auch gegenüber dem Geigerstrom gezielt verändern, ihn insbesondere verstärken. Es steht dafür an dem Kopplungselement 32 nahezu der vollständige Strom des Lawinendurchbruchs zur Verfügung. Der Messstrom ist anschließend ausgangsseitig als Detektionsergebnis zur Weiterverarbeitung abgreifbar. Der Messstrom speist sich aus einer Stromquelle des aktiven Kopplungselements 32 und nicht aus dem Lawinenphotodiodenelement 10.

Dabei sind zum dritten Eingangskreis und Ausgangkreis voneinander entkoppelt. Die Weiterverarbeitung des Messstroms hat also, in den technischen Grenzen einer realen Entkopplung, keinerlei Auswirkungen auf den Geigerstrom. Deshalb sind praktisch beliebige Nachfolgestufen möglich, die anders als herkömmliche Signalabgriffe keine ungünstigen Rückwirkungen auf den Geigerstrom haben.

Im konkreten Beispiel der Figur 1 bildet der Emitter des aktiven Kopplungselements 32 den Eingang 34, dem von dem Anschluss 28 des Lawinenphotodiodenelements 10 der Geigerstrom zugeführt wird. Die Basis ist mit Masse oder allgemeiner einem festen Potential verbunden und damit virtuell kurzgeschlossen. Der Kollektor bildet den Ausgang 36, an dem der Messstrom bereitgestellt wird. Im Emitterkreis des Transistors befindet sich noch eine Konstantstromquelle 38 zwischen Eingang 34 und einer Versorgungsspannung -U₂. Dadurch fließt hier zu Zeiten außerhalb von Lawinendurchbrüchen ein Gleichstrom, der den Arbeitspunkt des Transistors einstellt. Die Konstantstromquelle 38 kann alternativ passiv durch einen Widerstand 40 realisiert sein oder als Kombination aus beidem, wie in Figur 1 gezeigt. Am Ausgang 36 wird der Messstrom abgegriffen. Eine einfache Messimpedanz 42 ist nur ein Beispiel beliebiger Messschaltungen, die weitere aktive und/oder passive Elemente aufweisen können. Durch die Entkopplung mittels der Signalabgriffschaltung 12 haben diese Messschaltungen praktisch keine Rückwirkung auf die eigentliche Messung.

Figur 2 illustriert das Hochfrequenzverhalten der Signalabgriffschaltung gemäß Figur 1 als Ergebnis eines Testaufbaus, in dem ein Laser ein Signal auf einen Lichtempfänger mit einer Vielzahl von Lawinenphotoelementen 10 strahlt, wobei das Laserlicht in seiner Amplitude mit einer variierenden Frequenz von 100 kHz bis 3GHz moduliert wird. Dabei entspricht der obere Verlauf 44 dem Ergebnis mit der Signalabgriffschaltung 12 und der untere Verlauf 46 zum Vergleich einem herkömmlichen Signalabgriff. Die Signalabgriffschaltung 12 zeigt einen sehr flachen Frequenzgang mit einer Bandbreite von 2GHz und einem deutlichen Signalabfall erst jenseits von 2-3 GHz. Das ist gegenüber dem unteren Verlauf 46 eine Vervielfachung, wo das Messsignal schon bei moderaten Frequenzen lange vor dem GHz-Bereich einbricht.

Figur 3 zeigt eine schematische Schaltungsanordnung eines Lichtempfängers 50 mit einer Vielzahl von *m x n* Lawinenphotodiodenelementen 10₁₁ ... 10ₘₙ, die in einer Matrix mit *m* Spalte und *n* Zeilen angeordnet sind. Die einzelnen Lawinenphotodiodenelemente 10₁₁ ... 10ₘₙ können in ihrem Aufbau der Figur 1 entsprechen, auch wenn sie hier vereinfacht gezeigt sind. Außerdem ist in Figur 3 gegenüber Figur 1 die Position von Anschluss 28 und Widerstand 24 an der Diode 14 vertauscht, um zu illustrieren, dass deren anoden- wie kathodenseitige Verschaltung möglich ist. Die Anzahl an Lawinenphotodiodenelementen 10₁₁ ... 10ₘₙ variiert je nach Bauteil und Zielanforderungen und kann bis zu mehreren tausend und darüber hinaus betragen. Dabei können Lawinenphotodiodenelemente abweichend von der Darstellung auch gruppenweise elektrisch zusammengeschaltet sein. Die einzelnen Matrixpositionen sind dann also von mehreren Lawinenphotodiodenelementen besetzt, die ein gemeinsames Summensignal liefern. Dies ermöglicht statistische Verfahren, die ausgleichen, dass ein einzelnes Lawinenphotodiodenelement im Geiger-Modus einerseits schon durch ein einziges Fremdlichtphoton fehlausgelöst werden kann und andererseits nach jedem Auslösen einige Zeit lang nicht aktivierbar ist.

Das Detektionssignal der Lawinenphotodiodenelemente 10₁₁ ... 10ₘₙ wird jeweils doppelt an dem Anschluss 28 über eine jeweilige Zeilenleitung 52₁..52ₙ und den Zeilen zugeordnete Signalabgriffschaltungen 12a1...12an sowie an dem Anschluss 22 über eine jeweilige Spaltenleitung 54₁...54ₘ und den Spalten zugeordnete Signalabgriffschaltungen 12b1...12bm abgegriffen. Durch diese Art des Auslesens kann festgestellt, werden, welches Lawinenphotodiodenelement 10₁₁ ... 10ₘₙ ein Detektionsereignis ausgelöst hat. Der Lichtempfänger 50 wird damit ortsauflösend.

Die Lawinenphotodiodenelemente 10₁₁ ... 10ₘₙ werden über die Spannungsquellen VCC6 und VCC1 und deren Vorwiderstände R111...R1n1 vorgespannt. In den Signalabgriffschaltungen 12a1...12an, 12b1...12bm wurde die Funktion der aktiven Kopplungselemente 32 im Zusammenhang mit Figur 1 bereits erläutert. Sie gewährleisten einen möglichst kleinen Eingangswiderstand, der sicherstellt, dass sich die Spannungen bei einem Lawinenereignis kaum ändern. Damit haben auch größere Schaltungskapazitäten, die bei der Vielzahl verschalteter Lawinenphotodiodenelemente 10₁₁ ... 10ₘₙ unvermeidlich sind, kaum einen Einfluss auf das Empfangssignal, weil es kaum zu Umladeprozessen kommt, der Signalstrom nahezu vollständig zur Verfügung steht und das Signal sehr gute Hochfrequenzeigenschaften zeigt.

In den Signalabgriffschaltungen 12a1...12an der Zeilen ergibt sich der Ruhestrom des aktiven Kopplungselements 32 aus der Spannungsquelle VCC4, abzüglich U_{be}, und dem jeweiligen Widerstand R411...R41n. Die Spannungsquelle VCC5 versorgt die Transistorstufe. Am Widerstand R511...R51n kann die Signalspannung ausgekoppelt werden, bei der es sich um einen negativer Puls handelt, der einer positiven Gleichspannung/Ruhespannung überlagert ist. Bricht nun die Diode D11 beispielsweise des Lawinenphotodiodenelements 10₁₁ durch, so wird über den Kondensator C11 ein negativer Strompuls auf die Zeilen-Signalleitung aufgekoppelt und dem Emitter des Transistors T511 zugeführt. Damit steigt U_{be}, und der Kollektorstrom wird entsprechend zunehmen. Das Ausgangssignal U_Y1 wird einen negativen Spannungspuls ausgeben.

Die Signalabgriffschaltungen 12b1...12bm der Spalten sind über die Anoden ihrer jeweiligen Dioden 14 an die Spaltenleitungen 54₁...54ₘ angeschlossen. Deshalb wird bei einem Lawinendurchbruch ein positiver Strompuls über die Koppelkondensatoren C211...C2m1 auf den Emitter T311...T3m1 aufgekoppelt und am Kollektor beziehungsweise an R311...R3m1 abgegriffen. Der Arbeitspunkt der Transistoren T311...T3m1 wird hier über VCC2, abzüglich U_{be}, und den Widerstand R211...R2m1 festgelegt, und die Versorgung erfolgt über VCC3.

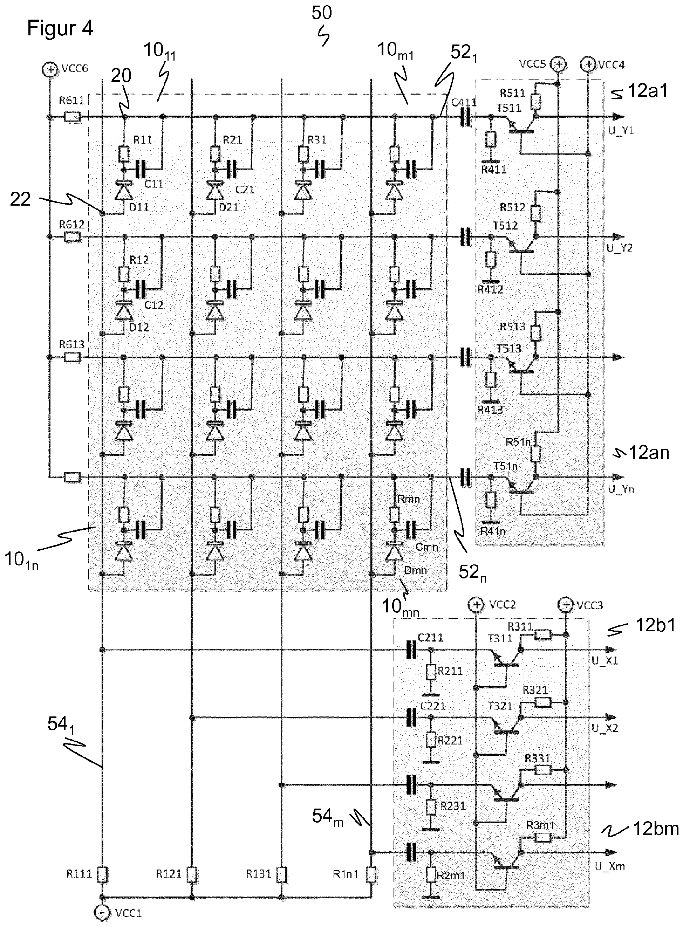

In der Ausführungsform gemäß Figur 3 sind Lawinenphotodiodenelemente 10₁₁ ... 10ₘₙ mit drei Anschlüssen 20, 22, 28 eingesetzt. Figur 4 zeigt eine alternative Ausführungsform mit zwei Anschlüssen 20, 22. Der Signalabgriff erfolgt somit an den Anschlüssen, über die auch die Vorspannung angelegt ist. Dafür ist der üblicherweise hochohmige Ladewiderstand R11...Rmn mit einem jeweiligen kleinen Kondensator C11...Cmn in einem Parallelzweig wechselstrommäßig überbrückt, um schnelle Strompulse bei einem Lawinendurchbruch niederohmig an die Signalabgriffschaltungen 12a1...12an, 12b1...12bm heranzuführen. Die Abläufe entsprechen insgesamt denjenigen in der Ausführungsform nach Figur 3.

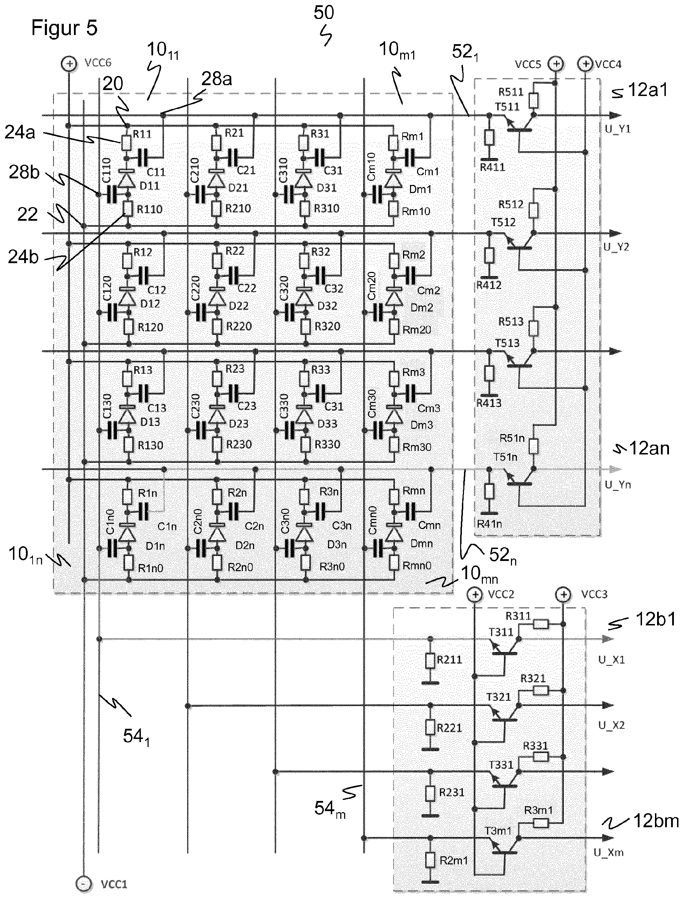

Figur 5 zeigt eine weitere alternative Ausführungsform, in der die Lawinenphotodiodenelemente 10₁₁ ... 10ₘₙ vier Anschlüsse 20, 22, 28a-b aufweisen. Dazu ist der Ladewiderstand 24a-b in zwei Anteile R11,R110...Rmn, RmnO aufgeteilt, insbesondere hälftig, die an der Kathode beziehungsweise an der Anode der Diode D11...Dmn angeschlossen sind, um die Vorspannung +VCC6 beziehungsweise -VCC1 zuzuführen. Ausgekoppelt werden die Signale über je einen Kondensator C11, C110...Cmn, CmnO an der Kathode beziehungsweise an der Anode. Gerade mit symmetrischer oder hälftiger Aufteilung können sich Vorteile beispielsweise im Hinblick auf möglichst geringe Laufzeitunterschiede zwischen den Zeilenleitungen 52₁...52ₙ und den Spaltenleitungen 54₁...54ₘ ergeben.

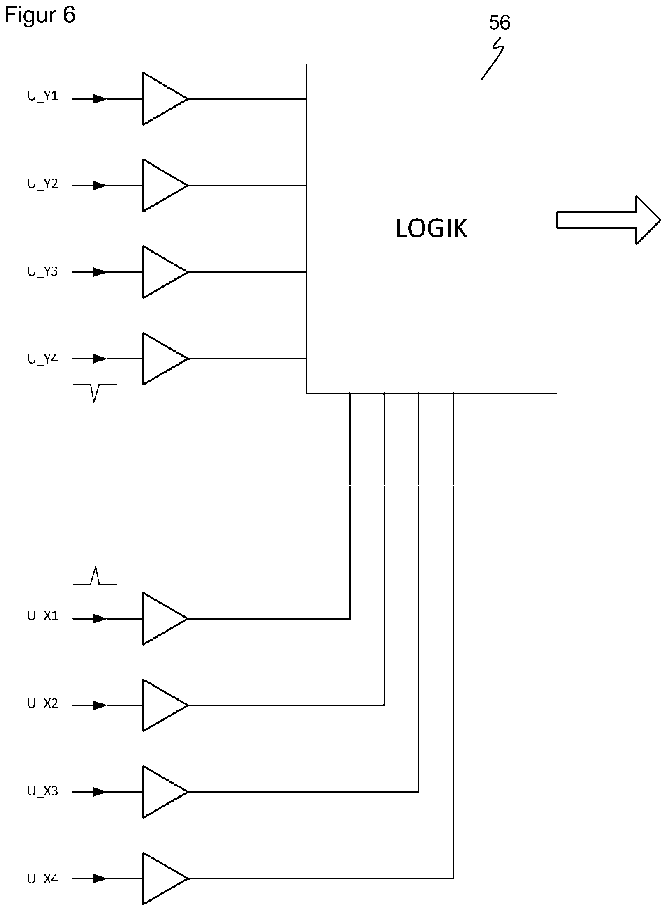

Figur 6 zeigt eine Blockdarstellung einer Logik 56 zum Zuordnen eines Detektionsereignisses zu einem Lawinenphotodiodenelement 10₁₁ ... 10ₘₙ. Aufgabe dieser Logik 56 ist, diese Zuordnung durch Verknüpfung der Y-Signale mit den X-Signalen vorzunehmen. Dabei können die Eingangssignale vorverarbeitet, hier beispielhaft verstärkt werden.

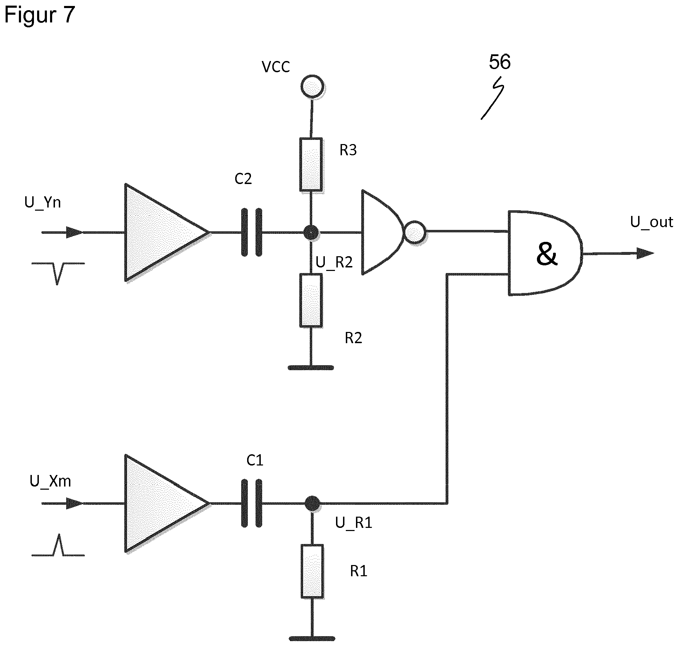

Figur 7 zeigt eine beispielhafte einfache Schaltungsanordnung für die Logik 56. Dabei werden die Signale Xₘ und Yₙ über eine UND-Logik miteinander verknüpft. Im Ruhezustand liegt an beiden Eingängen der UND-Logik ein LOW Potential an. Dies wird für die X-Signalleitung mit einem Ableitwiderstand R1 nach Masse in Kombination mit einem vorgeschalteten Kondensator C1 erreicht. Da die Eingangssignale auf der Y-Signalleitung negativ sind, wird hier noch ein Inverter angeordnet. Damit auch hier am Eingang des UND-Gatters in Ruhe ein LOW Potential anliegt, wird der Eingang des Inverters über einen Spannungsteiler auf ein HIGH Potential gezogen. Mit entsprechenden Anpassungen können statt einer UND-Logik auch ODER-, NAND- oder NOR-Gatter verwendet werden.

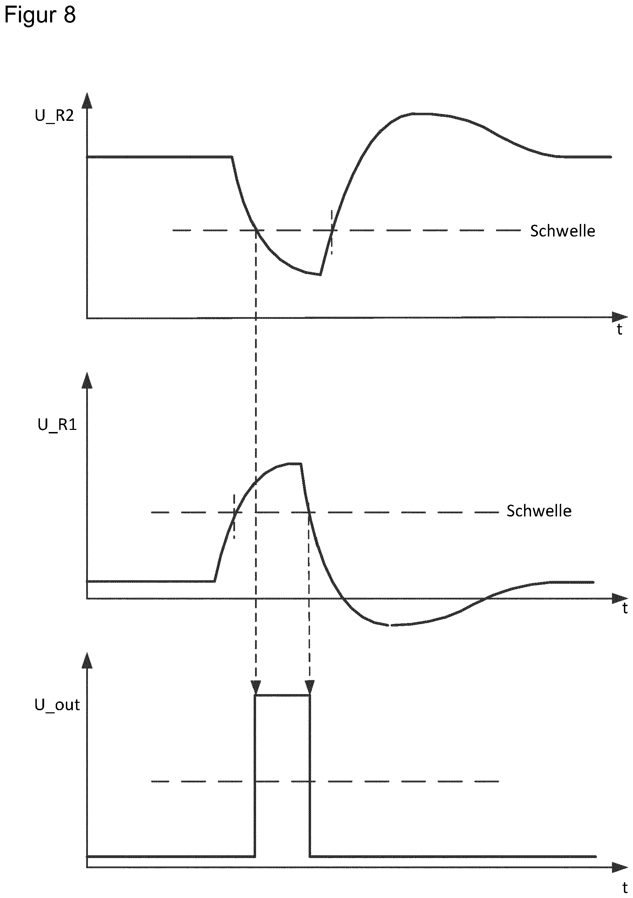

Figur 8 zeigt beispielhafte Signalverläufe an verschiedenen Punkten der Schaltungsanordnung gemäß Figur 7, nämlich oben die Spannung U_R2 des Y-Signals, in der Mitte die Spannung U_R1 des X-Signals und unten die Ausgangsspannung U_out. Im Ruhezustand ist die Spannung U_R2 HIGH und die Spannung U_R1 LOW. Die Ausgangsspannung wird genau dann HIGH, wenn sowohl U_R2 auf LOW als auch U_R1 auf HIGH wechselt. Im Beispiel der Figur 8 ist zur exemplarischen Verdeutlichung der Spannungsverlauf U_R2 etwas verzögert gegenüber U_R1. Dies hat zur Folge, dass der Ausgangsspannungspuls in U_out etwas kürzer ist als die Eingangspulse. Grundsätzlich sollen die Laufzeiten der beiden Signalleitungen X bzw. Y sehr ähnlich bzw. im Idealfall gleich groß sein, um einer derartigen Reduktion der Pulsbreite entgegenzuwirken.

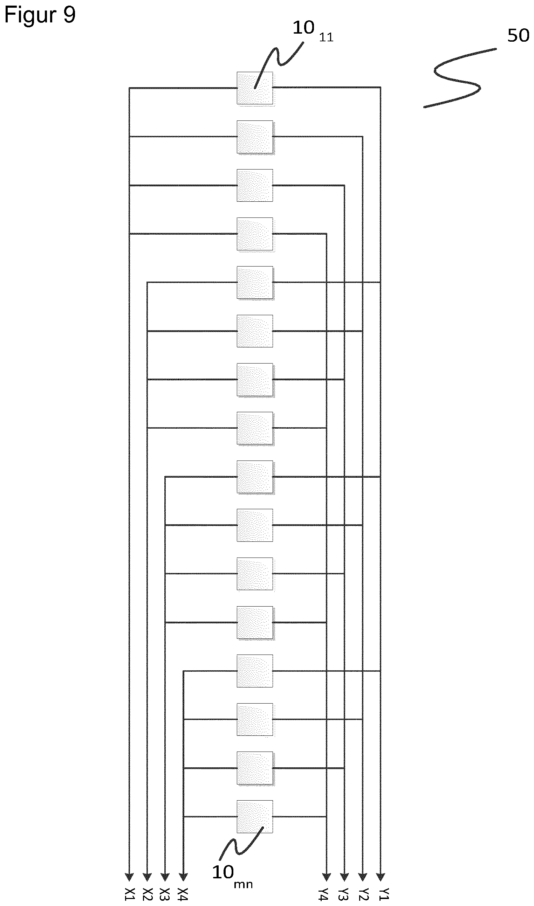

Figur 9 zeigt eine alternative lineare Anordnung von Lawinenphotodiodenelementen 10₁₁ ... 10ₘₙ. Auch hier ermöglicht der doppelte Signalabgriff eine örtliche Zuordnung von Detektionsereignissen. Der erste Signalabgriff unterteilt die Lawinenphotodiodenelemente 10₁₁ ... 10ₘₙ in Gruppen, während der zweite Signalabgriff jeweils das i-te Lawinenphotodiodenelement 10₁₁ ... 10ₘₙ einer Gruppe ausliest. Damit entspricht die Schaltungstopologie im Grunde den Figuren 3 bis 5, und es sind auch die dort gezeigten Varianten möglich. Lediglich die geometrische Anordnung der Lawinenphotodiodenelemente 10₁₁ ... 10ₘₙ ist anders. Eine Linearanordnung ist nur ein Beispiel. Außerdem kann in weiteren Ausführungsbeispielen auch die Schaltungstopologie varriert werden, also die Zuordnung der beiden Signalabgriffe.

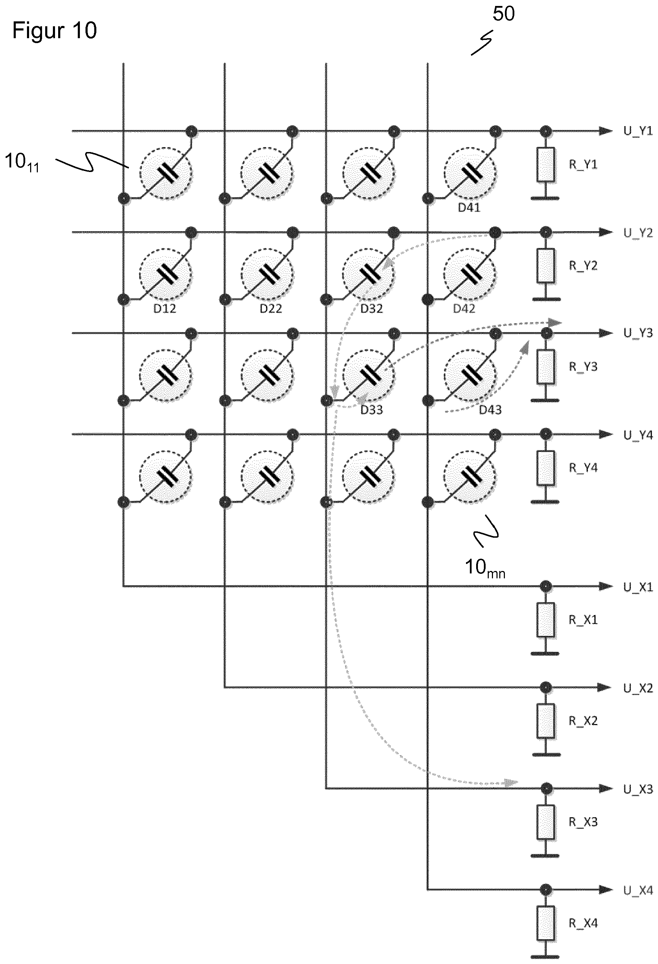

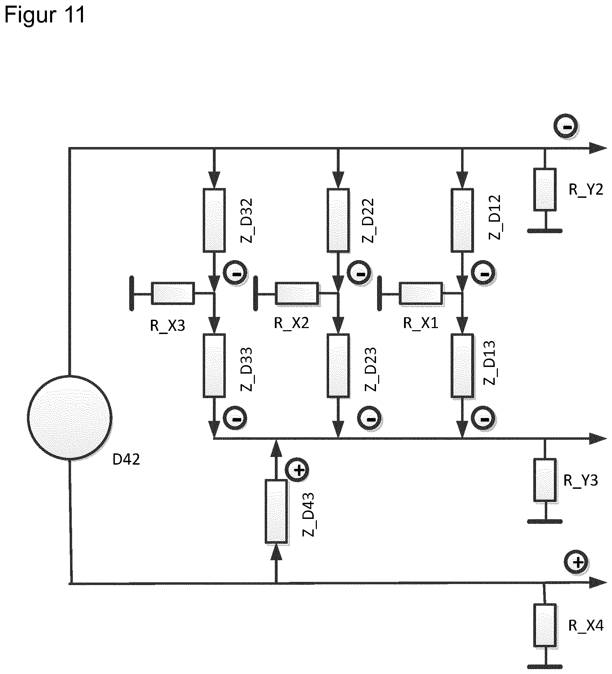

Bei einer Matrixanordnung mit zahlreichen parallel geschalteten Lawinenphotodiodenelementen 10₁₁ ... 10ₘₙ ergeben sich meist Probleme durch Übersprecheffekte. Durch die besonders niederohmige oder virtuell kurzgeschlossene Signalabgriffschaltung 12 wird das Übersprechen stark reduziert, weil es nur sehr kleine Spannungsänderungen beziehungsweise Signalspannungen in den Matrixleitungen gibt. Dies soll abschließend unter Bezugnahme auf die Figuren 10 und 11 erläutert werden.

Figur 10 zeigt die Matrixanordnung des Lichtempfängers 50, wobei der Übersichtlichkeit halber zahlreiche Elemente weggelassen, die Lawinenphotodiodenelemente auf eine Anzahl von 4 x 4 reduziert und entsprechend ihrer für das Übersprechen relevanten Eigenschaften nur als Kondensatoren dargestellt sind. Wenn jetzt beispielsweise D42 auslöst, ist das Messsignal an U_Y2 und in entgegengesetzter Polarität an U_X4 zu messen. R_Y und R_X stellen die differentiellen Eingangswiderstände der Signalabgriffschaltungen dar. Wenn nun R_Y2 nicht sehr niederohmig ist, so wird es über die Zelle D32 zu einer gewissen Überkopplung von U_Y2 auf U_X3 kommen. Über die entsprechenden Zellen D12 und D22 werden folglich Signalanteile auf U_X1 und U_X2 übergekoppelt. Zu beachten ist dabei, dass die Polarität des Übersprechsignals zu U_X4 gegenläufig ist. Über die Zelle D33 werden ebenfalls Signalanteile auf U_Y3 übergekoppelt. Diese sind jedoch doppelt gedämpft und deshalb sehr schwach. Vielmehr kommt es hier zu einer gegenphasigen Überkopplung über Zelle D43. Sind dagegen die differentiellen Eingangswiderstände sehr niederohmig oder virtuell kurzgeschlossen, wie in einer Signalabgriffschaltung entsprechend Figur 1, so werden die geschilderten Störeffekte erheblich herabgesetzt. Diese Betrachtung dient nur der Illustration und ist unvollständig, denn es gibt eine Reihe weiterer Koppelwege.

Figur 11 zeigt einen Schaltungsausschnitt für die auslösende Diode D42. Der negative und positive Puls, hier dargestellt durch Minus- und Plus-Zeichen im Kreis, wird von D42 dem Widerstand R_Y2 beziehungsweise R_X4 zugeführt. Es sollen nun wesentliche Übersprechterme für R_Y3 betrachtet werden. Die Widerstände der einzelnen Lawinenphotodiodenelemente sind als komplexe Widerstände Z gezeigt. Der stärkste Übersprechweg verläuft gegenphasig zu dem Signal an R_Y2 über nur den einen Widerstand Z_D43. Zudem gibt es eine Anzahl von parallelen Übersprechwegen über jeweils zwei Widerstände in Längsrichtung, die R_Y3 gleichphasig wie R_Y2 auslenken. Diese Übersprechwege beinhalten jedoch Spannungsteiler mit Z_D12, Z_D22 beziehungsweise Z_D32 im Signalweg und R_X1, R_X2 beziehungsweise R_X3 gegen Masse und sind somit deutlich schwächer. Das illustriert erneut, wie vorteilhaft möglichst kleine Widerstände R_X und R_Y für ein geringes Übersprechen sind.

## Patentansprüche

1. Lichtempfänger (50) mit einer Vielzahl von Lawinenphotodiodenelementen (10), die jeweils mit einer Vorspannung oberhalb einer Durchbruchspannung vorgespannt und somit in einem Geiger-Modus betrieben sind, um bei Lichtempfang einen Geigerstrom auszulösen, wobei die Lawinenphotodiodenelemente (10) einen ersten Anschluss (20, 22, 28a-b) und einen zweiten Anschluss (20, 22, 28a-b) aufweisen und wobei eine erste Signalabgriffschaltung (12) zum Auslesen der Lawinenphotodiodenelemente mit einem der Anschlüsse (20, 22, 28a-b) und eine zweite Signalabgriffschaltung (12) zum Auslesen der Lawinenphotodiodenelemente (10) mit dem anderen Anschluss (20, 22, 28a-b) verbunden ist,
**dadurch gekennzeichnet,**
**dass** die Lawinenphotodiodenelemente (10) einen dritten Anschluss (20, 22) aufweisen, der erste Anschluss (28) zum kapazitiven Auskoppeln des Geigerstroms ausgebildet ist und die Lawinenphotodiodenelemente (10) über den zweiten Anschluss (20, 22) und den dritten Anschluss (22, 20) vorgespannt sind oder dass die Lawinenphotodiodenelemente (10) einen dritten Anschluss (20) und einen vierten Anschluss (22) aufweisen und jeweils zwischen Lawinenphotodiodenelement (10) und dem dritten Anschluss (20) eine erste Ladeeinheit (R11...Rmn) und zwischen dem Lawinenphotodiodenelement (10) und dem vierten Anschluss (22) eine zweite Ladeeinheit (R110...Rmn0) angeordnet ist, und wobei die Lawinenphotodiodenelemente (10) über den dritten Anschluss (20) und den vierten Anschluss (22) vorgespannt sind.

2. Lichtempfänger (50) nach Anspruch 1,
wobei die erste Signalabgriffschaltung (12) und/oder die zweite Signalabgriffschaltung (12) ein aktives Kopplungselement (32) mit einem Eingang (34), der mit einem der Anschlüsse (20, 22, 28a-b) verbunden ist, und mit einem Ausgang (36) aufweist, wobei das Kopplungselement (32) einen Geigerstrom des jeweiligen Lawinenphotodiodenelements (10) am Eingang (34) auf einen in Verlauf und Pegel dem Geigerstrom entsprechenden Messstrom abbildet, indem der Eingang (34) für den Geigerstrom einen virtuellen Kurzschluss gegen ein Potential bildet und der Ausgang (36) von dem Eingang (34) entkoppelt ist.

3. Lichtempfänger (50) nach Anspruch 1 oder 2,
wobei der erste Anschluss (20, 22, 28a-b) auf der Anodenseite und der zweite Anschluss (20, 22, 28a-b) auf der Kathodenseite des jeweiligen Lawinenphotodiodenelements (10) angeordnet ist.

4. Lichtempfänger (50) nach einem der vorhergehenden Ansprüche,
wobei die erste Ladeeinheit (R11...Rmn) mit einem ersten parallel geschalteten Kondensator (C11...Cmn) auf den ersten Anschluss (20) und die zweite Ladeeinheit (R110...Rmn0) mit einem zweiten parallel geschalteten Kondensator (C110...Cmn0) auf den zweiten Anschluss (22) überbrückt ist.

5. Lichtempfänger (50) nach einem der vorhergehenden Ansprüche,
wobei die Lawinenphotodiodenelemente 10₁₁ ... 10ₘₙ) eine Matrixanordnung bilden, wobei eine Vielzahl von ersten Signalabgriffschaltungen (12b1...12bm) jeweils mit den ersten Anschlüssen (20) der Lawinenphotodiodenelementen einer Spalte und eine Vielzahl von zweiten Signalabgriffschaltungen (12a1...12an) jeweils mit den zweiten Anschlüssen (22) der Lawinenphotodiodenelemente einer Zeile verbunden ist.

6. Lichtempfänger (50) nach einem der Ansprüche 1 bis 4,
wobei die Lawinenphotodiodenelemente (10) eine in Gruppen unterteilbare Linienanordnung bilden, wobei eine Vielzahl von ersten Signalabgriffschaltungen (12) jeweils mit den ersten Anschlüssen (20, 22, 28a-b) der Lawinenphotodiodenelemente (10) einer Gruppe und eine Vielzahl von zweiten Signalabgriffschaltungen (12) jeweils mit den zweiten Anschlüssen (20, 22, 28a-b) eines Lawinenphotodiodenelements (10) aus jeder Gruppe verbunden ist.

7. Lichtempfänger (50) nach einem der vorhergehenden Ansprüche,
wobei Lawinenphotodiodenelemente (10) parallel geschaltet sind und ein gemeinsames Signal erzeugen.

8. Optoelektronischer Sensor mit mindestens einem Lichtempfänger (50) nach einem der vorhergehenden Ansprüche, wobei der Sensor zur Entfernungsmessung nach einem Lichtlaufzeitverfahren und/oder als Codeleser und/oder zur Datenübertragung ausgebildet ist.

9. Verfahren zum Auslesen von Lawinenphotodiodenelementen (10), die jeweils mit einer Vorspannung oberhalb einer Durchbruchspannung vorgespannt und somit in einem Geiger-Modus betrieben werden, wobei die Lawinenphotodiodenelemente (10) bei Lichtempfang einen Geigerstrom auslösen, wobei die Lawinenphotodioden (10) von einer ersten Signalabgriffschaltung (12) ausgelesen werden, die mit einem ersten Anschluss (20, 22, 28a-b) der Lawinenphotodiodenelemente (10) verbunden ist, und von einer zweiten Signalabgriffschaltung (12) ausgelesen werden, die mit einem zweiten Anschluss (20, 22, 28a-b) der Lawinenphotodiodenelemente (10) verbunden ist,
**dadurch gekennzeichnet,**
**dass** an dem ersten Anschluss (28) der Geigerstrom kapazitiv ausgekoppelt wird und die Lawinenphotodiodenelemente (10) über den zweiten Anschluss (20, 22) und einen dritten Anschluss (22, 20) vorgespannt sind oder dass jeweils zwischen Lawinenphotodiodenelement (10) und einem dritten Anschluss (20) eine erste Ladeeinheit (R11...Rmn) und zwischen dem Lawinenphotodiodenelement (10) und einem vierten Anschluss (22) eine zweite Ladeeinheit (R110...Rmn0) angeordnet ist und die Lawinenphotodiodenelemente (10) über den dritten Anschluss (20) und den vierten Anschluss (22) vorgespannt sind.

10. Verfahren nach Anspruch 9,
wobei in der ersten Signalabgriffschaltung (12) und/oder der zweiten Signalabgriffschaltung (12) ein mit einem der Anschlüsse (20, 22, 28a-b) verbundener Eingang (34) eines aktiven Kopplungselements (32) für den Geigerstrom virtuell gegen ein Potential kurzgeschlossen ist, so dass der Geigerstrom praktisch unverändert in das Kopplungselement (32) fließt und dort auf einen in Verlauf und Pegel dem Geigerstrom entsprechenden Messstrom an einem Ausgang (36) des Kopplungselements (32) abgebildet wird, wobei der Ausgang (36) von dem Eingang (34) entkoppelt ist.

11. Verfahren nach Anspruch 9 oder 10,
wobei die Lawinenphotodiodenelemente 10₁₁ ... 10ₘₙ) eine Matrixanordnung bilden und jedes Lawinenphotodiodenelement einerseits über eine seiner Spalte zugeordnete erste Signalabgriffschaltung (12b1...12bm) und andererseits über eine seiner Zeile zugeordnete zweite Signalabgriffschaltung (12a1...12bn) ausgelesen wird.

## Claims

1. A light receiver (50) having a plurality of avalanche photodiode elements (10) that are each biased by a bias above a breakdown voltage and that are thus operated in a Geiger mode to trigger a Geiger current on light reception, wherein the avalanche photodiode elements (10) have a first connector (20, 22, 28a-b) and a second connector (20, 22, 28a-b) and wherein a first signal tapping circuit (12) for reading out the avalanche photodiode elements (10) is connected to one of the connectors (20, 22, 28a-b) and a second signal tapping circuit (12) for reading out the avalanche photodiode elements (10) is connected to the other connector (20, 22, 28a-b),
**characterized in that** the avalanche photodiode elements (10) have a third connector (20, 22), with the first connector (28) being configured for a capacitive decoupling of the Geiger current and with the avalanche photodiode elements (10) being biased via the second connector (20, 22) and the third connector (22, 20)
or **in that** the avalanche photodiode elements (10) have a third connector (20) and a fourth connector (22) and a first charge unit (R11..Rmn) is respectively arranged between the avalanche photodiode element (10) and the third connector (20) and a second charge unit (R110..Rmn0) is respectively arranged between the avalanche photodiode element (10) and the fourth connector (22) and wherein the avalanche photodiode elements (10) are biased via the third connector (20) and the fourth connector (20).

2. The light receiver (509 in accordance with claim 1,
wherein at least one of the first signal tapping circuit (12) and the second signal tapping circuit (12) has an active coupling element (32), the active coupling element (32) having an input (34) that is connected to one of the connectors (20, 22, 28a-b) and having an output (36), wherein the coupling element (32) maps a Geiger current of the respective avalanche photodiode element (10) at the input (34) to a measured current corresponding in its course and level to the Geiger current in that the input (32) forms a virtual short circuit for the Geiger current against a potential and the output (36) is decoupled from the input (34).

3. The light receiver (50) in accordance with claim 1 or 2,
wherein the first connector (20, 22, 28a-b) is arranged on the anode side and the second connector (20, 22, 28a-b) is arranged on the cathode side of the respective avalanche photodiode element (10).

4. The light receiver (50) in accordance with any one of the preceding claims,
wherein the first charge unit (r11..Rmn) is bridged to the first connector (20) by a first capacitor (C11...Cmn) connected in parallel and the second charge unit (R110..Rmno) is bridged to the second connector (22) by a second capacitor (C110...Cmn0) connected in parallel.

5. The light receiver (50) in accordance with any one of the preceding claims,
wherein the avalanche photodiode elements (10₁₁..10ₘₙ) form a matrix arrangement, wherein a plurality of first signal tapping circuits (12b1...12bm) are each connected to the first connectors (20) of the avalanche photodiode elements of a column and a plurality of second signal tapping circuits (12a1...12an) are each connected to the second connectors (22) of the avalanche photodiode elements of a row.

6. The light receiver (50) in accordance with any one of claims 1 to 4,
wherein the avalanche photodiode elements (10) form a linear arrangement divisible into groups, wherein a plurality of first signal tapping circuits (12) are each connected to the first connectors (20, 22, 28a-b) of the avalanche photodiode elements (10) of a group and a plurality of second signal tapping circuits (12) are each connected to the second connectors (20, 22, 28a-b) of an avalanche photodiode element (10) from each group.

7. The light receiver (50) in accordance with any one of the preceding claims,
wherein avalanche photodiode elements (10) are connected in parallel and generate a common signal.

8. An optoelectronic sensor having at least one light receiver (50) according to any one of the preceding claims, wherein the sensor is configured for distance measurement in accordance with a time of flight process and/or as a code reader and/or for data transmission.

9. A method for reading out avalanche photodiode elements (10) that are each biased by a bias above a breakdown voltage and are thus operated in a Geiger mode, wherein the avalanche photodiode elements (10) trigger a Geiger current on light reception, wherein the avalanche photodiodes (10) are read out by a first signal tapping circuit (12) that is connected to a first connector (20, 22, 28a-b) of the avalanche photodiode elements (10) and are read out by a second signal tapping circuit (12) that is connected to a second connector (20, 22, 28a-b) of the avalanche photodiode elements (10),
**characterized in that** the Geiger current is capacitively decoupled at the first connector (28) and the avalanche photodiode elements (10) are biased via the second connector (20, 22) and a third connector (22, 20)
or **in that** a first charge unit (R11..Rmn) is respectively arranged between the avalanche photodiode element (10) and a third connector (20) and a second charge unit (R110..Rmn0) is arranged between the avalanche photodiode element (10) and a fourth connector (22) and the avalanche photodiode elements (10) are biased via the third connector (20) and the fourth connector (20).

10. The method in accordance with claim 9,
wherein an input (34) of an active coupling element (34) for the Geiger current in the first and/or second signal tapping circuit (12) connected to one of the connectors (20, 22, 28a-b) is virtually short circuited against a potential so that the Geiger current flows into the coupling element (32) virtually without change and is mapped there onto a measurement current corresponding to the Geiger current in its course and level at an output (36) of the coupling element (32), wherein the output (36) is decoupled from the input (34).

11. The method in accordance with claim 9 or 10,
wherein the avalanche photodiode elements (10₁₁...10ₘₙ) form a matrix arrangement and each avalanche photodiode element is read out, on the one hand, via a first signal tapping circuit (12b1...12bm) associated with its column and, on the other hand, is read out via a second signal tapping circuit (12a1...12bn) associated with its row.

## Revendications

1. Récepteur de lumière (50) comportant une multitude d'éléments formant photodiodes à avalanche (10) qui sont polarisés chacun par une tension de polarisation supérieure à une tension de claquage et qui fonctionnent donc en mode Geiger, afin de déclencher un courant Geiger lors de la réception d'une lumière, les éléments formant photodiodes à avalanche (10) comprenant un premier raccord (20, 22, 28a-b) et un second raccord (20, 22, 28a-b), et un premier circuit de prélèvement de signal (12) pour lire les éléments formant photodiodes à avalanche étant connecté à l'un des raccords (20, 22, 28a-b), et un second circuit de prélèvement de signal (12) pour lire les éléments formant photodiodes à avalanche (10) étant connecté à l'autre raccord (20, 22, 28a-b),
**caractérisé en ce que**
les éléments formant photodiodes à avalanche (10) comprennent un troisième raccord (20, 22), le premier raccord (28) est réalisé pour le découplage capacitif du courant Geiger, et les éléments formant photodiodes à avalanche (10) sont polarisés par le second raccord (20, 22) et par le troisième raccord (22, 20), ou
**en ce que**
les éléments formant photodiodes à avalanche (10) comprennent un troisième raccord (20) et un quatrième raccord (22), et une première unité de chargement (R11 ... Rmn) est agencée entre l'élément formant photodiode à avalanche (10) et le troisième raccord (20), et une seconde unité de chargement (R110 ... Rmn0) est agencée entre l'élément formant photodiode à avalanche (10) et le quatrième raccord (22), et les éléments formant photodiodes à avalanche (10) sont polarisés par le troisième raccord (20) et par le quatrième raccord (22).

2. Récepteur de lumière (50) selon la revendication 1,
dans lequel le premier circuit de prélèvement de signal (12) et/ou le second circuit de prélèvement de signal (12) comprend un élément de couplage actif (32) avec une entrée (34) connectée à l'un des raccords (20, 22, 28a-b) et avec une sortie (36), dans lequel l'élément de couplage (32) reproduit un courant Geiger de l'élément formant photodiode à avalanche (10) respectif à l'entrée (34) sur un courant de mesure correspondant au courant Geiger quant à l'évolution et au niveau, du fait que l'entrée (34) pour le courant Geiger forme un court-circuit virtuel avec un potentiel et que la sortie (36) est découplée de l'entrée (34).

3. Récepteur de lumière (50) selon la revendication 1 ou 2,
dans lequel le premier raccord (20, 22, 28a-b) est agencé sur le côté anode et le second raccord (20, 22, 28a-b) est agencé sur le côté cathode de l'élément formant photodiode à avalanche respectif (10).

4. Récepteur de lumière (50) selon l'une des revendications précédentes,
dans lequel la première unité de chargement (R11 ... Rmn) est pontée sur le premier raccord (20) par un premier condensateur (C11 ... Cmn) branché en parallèle, et la seconde unité de chargement (R110 ... Rmn0) est pontée sur le second raccord (22) par un second condensateur (C110 ... Cmn0) branché en parallèle.

5. Récepteur de lumière (50) selon l'une des revendications précédentes,
dans lequel les éléments formant photodiodes à avalanche 10₁₁ ... 10ₘₙ) constituent un agencement en matrice, une multitude de premiers circuits de prélèvement de signal (12b1 ... 12bm) étant reliés respectivement aux premiers raccords (20) des éléments formant photodiodes à avalanche d'une colonne, et une multitude de seconds circuits de prélèvement de signal (12a1 ... 12an) étant reliés respectivement aux seconds raccords (22) des éléments formant photodiodes à avalanche d'une ligne.

6. Récepteur de lumière (50) selon l'une des revendications 1 à 4,
dans lequel les éléments formant photodiodes à avalanche (10) constituent un agencement en ligne susceptible d'être subdivisé en groupes, une multitude de premiers circuits de prélèvement de signal (12) étant reliés respectivement aux premiers raccords (20, 22, 28a-b) des éléments formant photodiodes à avalanche (10) d'un groupe, et une multitude de seconds circuits de prélèvement de signal (12) étant reliés respectivement aux seconds raccords (20, 22, 28a-b) d'un élément formant photodiode à avalanche (10) de chaque groupe.

7. Récepteur de lumière (50) selon l'une des revendications précédentes,
dans lequel les éléments formant photodiodes à avalanche (10) sont branchés en parallèle et génèrent un signal commun.

8. Capteur optoélectronique comportant au moins un récepteur de lumière (50) selon l'une des revendications précédentes,
dans lequel le capteur est réalisé pour la télémétrie selon la méthode du temps de vol de lumière et/ou à titre de lecteur de code et/ou pour la transmission de données.

9. Procédé de lecture d'éléments formant photodiodes à avalanche (10) qui sont polarisés chacun par une tension de polarisation supérieure à une tension de claquage et qui fonctionnent donc en mode Geiger, dans lequel les éléments formant photodiodes à avalanche (10) déclenchent un courant Geiger lors de la réception d'une lumière, les éléments formant photodiodes à avalanche (10) sont lus par un premier circuit de prélèvement de signal (12) qui est connecté à un premier raccord (20, 22, 28a-b) des éléments formant photodiodes à avalanche (10), et sont lus par un second circuit de prélèvement de signal (12) qui est connecté à un second raccord (20, 22, 28a-b) des éléments formant photodiodes à avalanche (10),
**caractérisé en ce que**
le courant Geiger est découplé par voie capacitive au niveau du premier raccord (28) et les éléments formant photodiodes à avalanche (10) sont polarisés par le second raccord (20, 22) et par un troisième raccord (22, 20), ou **en ce que** une première unité de chargement (R11 ... Rmn) est agencée respectivement entre l'élément formant photodiode à avalanche (10) et un troisième raccord (20), et une seconde unité de chargement (R110 ... Rmn0) est agencée respectivement entre l'élément formant photodiode à avalanche (10) et un quatrième raccord (22), et les éléments formant photodiodes à avalanche (10) sont polarisés par le troisième raccord (20) et par le quatrième raccord (22).

10. Procédé selon la revendication 9,
dans lequel dans le premier circuit de prélèvement de signal (12) et/ou dans le second circuit de prélèvement de signal, une entrée (34) pour le courant Geiger connectée à l'un des raccords (20, 22, 28a-b) d'un élément de couplage actif (32) est court-circuitée virtuellement avec un potentiel, de sorte que le courant Geiger circule pratiquement inchangé dans l'élément de couplage (32) et y est reproduit sur un courant de mesure correspondant au courant Geiger quant à l'évolution et au niveau à une sortie (36) de l'élément de couplage (32), la sortie (36) étant découplée de l'entrée (34).

11. Procédé selon la revendication 9 ou 10,
dans lequel les éléments formant photodiodes à avalanche (10₁₁ ... 10ₘₙ) constituent un agencement en matrice, et chaque élément formant photodiode à avalanche est lu d'une part par un premier circuit de prélèvement de signal (12b1 ... 12bm) associé à sa colonne et d'autre part par un second circuit de prélèvement de signal (12a1 ... 12bn) associé à sa ligne.
